# EUROPEAN PATENT APPLICATION

(11) **EP 3 246 107 A1**
(43) Date of publication of application: **22.11.2017**
(21) Application number: 17172154.1
(22) Date of filing: 22.05.2017
(51) Int. Cl.: B22C 7/02, B22C 9/04, B22D 25/02, B29C 33/38, B29C 67/24, B33Y 80/00, B29C 65/00, G06F 17/50, B29C 64/00, B29C 45/26, B33Y 10/00

(54) **METHOD OF INVESTMENT CASTING USING ADDITIVE MANUFACTURING**

(30) Priority: 20.05.2016 US 201615160798
(71) Applicant: LuxMea Studio, LLC, Somerville, MA 02143 (US)
(72) Inventor: YANG, Qian, Cambridge, 02141 (US); AVIS, Steven, Toronto, Ontario M5V 3Y3 (CA)
(74) Representative: Nordmeyer, Philipp Werner

(57) **Abstract**

The present disclosure provides a method of investment casting using additive manufacturing. In one aspect, the method includes: creating a digital model of a building component using one or more software tools executed on a computer device and importing the digital model in an additive manufacturing apparatus; producing a first physical specimen by controlling the additive manufacturing apparatus in accordance with the digital model; creating a first negative mold using the first physical specimen as a template, the first negative mold having a hollow space substantially defined by a surface profile of the first physical specimen; producing a second physical specimen using the first negative mold; creating a second negative mold enclosing the second physical specimen therein; producing a casting piece using the second negative mold; and finishing the casting piece to produce the building component.

## Description

### TECHNICAL FIELD

The present disclosure relates to a method of investment casting using additive manufacturing. More particularly, the present disclosure relates to a method of investment casting using additive manufacturing to produce building components of architectural constructions having highly complicated geometric shapes.

### BACKGROUND

Various methods exist to manufacture three-dimensional (3D) solid objects, e.g., building components. Such methods can be generally divided into subtractive manufacturing and additive manufacturing.

Subtractive manufacturing constructs a 3D object by successively cutting material away from a solid block. This can be done by manually cutting the material or, more typically, by using a computerized numerical control (CNC) machine. For example, glass-fiber-reinforced concrete (GRFC) can be milled using CNC to create a simple 3D form. Due to its poor bending strength, however, a panel made of GRFC is usually very thick and cannot have a complex 3D form.

On the other hand, additive manufacturing, a.k.a., 3D printing, constructs a 3D object by forming successive layers of material (e.g., plastic, metal, concrete, etc.), often under the control of a computer. Such a 3D object can be of almost any shape or geometry produced from a digital 3D model or other electronic data format.

For example, direct metal laser sintering (DMLS) is an additive manufacturing technique that uses a laser beam to grow a solid structure. A DMLS system fires a laser beam into a bed of powdered metal, aiming the laser automatically at points in space defined by a digital 3D model, melting and welding the material together to create the solid structure. For selected materials, DMLS can create a 3D object with very complicated shapes. Currently, however, the maximum supported build volume for a state of the art DMLS system is about 10.00 in. × 10.00 in. × 8.70 in. and DMLS is very expensive. Because a typical building component, such as a cladding panel, can be as large as 3 m x 2 m (or 118 in. × 79 in.), which significantly exceeds DMLS's maximum supported build volume, it is far from practical to use DMLS for making building components (e.g., cladding) to be used in an architectural construction.

Many other additive manufacturing technologies may be used to produce 3D objects. For example, fuse deposition modelling (FDM) is one form of additive manufacturing technology commonly used for modeling, prototyping, and production applications. Under FDM, material is drawn through a nozzle, where it is heated and is then deposited layer by layer. The nozzle can move horizontally and a platform moves up and down vertically after each new layer is deposited. In addition, stereolithography (SLA) is one form of additive manufacturing technology used for creating models, prototypes, patterns, and production parts in a layer by layer fashion. SLA uses photopolymerization, a process by which light causes chains of molecules to link together, thereby forming polymers. Moreover, selective heat sintering (SHS) is one form of additive manufacturing process using a thermal print head to apply heat to layers of powdered thermoplastic. When a layer is finished, the powder bed moves down, and an automated roller adds a new layer of material which is sintered to form the next cross-section of the model. None of the above methods, however, can be used to print building/cladding material directly due to material limitation to plastic (e.g., ABS, PVC, etc.), resin, and powder.

### SUMMARY

In view of the above, there is a need to develop a new method that can produce large sized building components (e.g., having a lateral size (width or length) of at least 1 meter) for architectural constructions with highly complicated geometric shapes. Therefore, it is an object of the present invention to provide a method of investment casting using additive manufacturing that overcomes the before-described drawbacks. This object is solved by the method according to claim 1.

Further objects of the invention are to provide a method of investment casting using additive manufacturing, a method of creating an investment casting mold for an object, and an additive manufacturing apparatus that overcome the drawbacks of the prior art as described above.

The present disclosure provides a method of investment casting using additive manufacturing to produce building components. The method of the present disclosure incorporates large-scale 3D printing technology and casting-molding technique. With the method of the present disclosure, large-sized building components become massively customizable and affordable. The present disclosure provides a powerful system to produce building components, thereby making it possible to design complex building components at a rapid speed and a lower cost.

In one aspect, the present disclosure provides a method of investment casting using additive manufacturing. The method comprises: creating a digital model of a building component using one or more software tools executed on a computer device and importing the digital model in an additive manufacturing apparatus; producing a first physical specimen by controlling the additive manufacturing apparatus in accordance with the digital model; creating a first negative mold using the first physical specimen as a template, the first negative mold having a hollow space substantially defined by a surface profile of the first physical specimen; producing a second physical specimen using the first negative mold; creating a second negative mold enclosing the second physical specimen therein; producing a casting piece using the second negative mold; and finishing the casting piece to produce the building component.

In one embodiment, creating the digital model comprises dividing the digital model into a plurality of digital model parts by applying a predetermined boundary rule to the digital model such that boundaries of neighboring digital model parts have complimentary shapes.

In one embodiment, the complimentary shapes comprise one of a linear shape, a sinusoidal wave shape, a square wave shape, a zigzag shape, and a random zigzag shape.

In one embodiment, producing the first physical specimen comprises: producing components of the first physical specimen by controlling one or more additive manufacturing apparatuses in accordance with the digital model parts, each of the digital model parts defining a respective one of the components of the first physical specimen; and combining the components to form the first physical specimen.

In one embodiment, controlling the additive manufacturing apparatus comprises sequentially applying layers of a plastic material to construct the first physical specimen.

In one embodiment, producing the second physical specimen comprises: pouring a hot liquid material into the hollow space of the first negative mold; and allowing the hot liquid material to cool down and solidify within the hollow space, thereby forming the second physical specimen.

In one embodiment, the hot liquid material comprises castable material (e.g., wax) and has a melting point below 100°C.

In one embodiment, producing the casting piece in the second negative mold comprises: heating the second negative mold to a temperature that liquefies the second physical specimen enclosed within the second negative mold to drain the second physical specimen out of the second negative mold, thereby forming a hollow space in the second negative mold; pouring a heated liquid material into the hollow space of the second negative mold to fill the hollow space; allowing the heated liquid material to cool down and solidify into a solid object, the solid object having substantially the same shape as defined by the digital model; and ejecting the solid object from the second negative mold to form the casting piece.

In one embodiment, pouring the heated liquid material comprises pouring a construction material having a melting point substantially greater than 100°C.

In one embodiment, the construction material comprises one of metal, glass, porcelain, and concrete.

In one embodiment, finishing the casting piece comprises polishing the casting piece in accordance with a desired finish.

In one embodiment, finishing the casting piece comprises coating the casting piece with a protection layer to increase durability.

In one embodiment, producing the first physical specimen comprises producing the first physical specimen having a 1-to-1 scale as defined in the digital model.

In one embodiment, the first physical specimen has a lateral size of at least one meter.

In accordance with another aspect, the present disclosure provides a method of investment casting using additive manufacturing. The method comprises: creating a digital model of a building component using one or more software tools executed on a computer device and importing the digital model in an additive manufacturing apparatus, the digital model comprises a plurality of digital model parts with boundaries of neighboring digital model parts having complimentary shapes; producing components of a first physical specimen by controlling one or more additive manufacturing apparatuses in accordance with the digital model parts, each of the digital model parts defining a respective one of the components of the first physical specimen, and combining the components to form the first physical specimen; creating a first negative mold using the first physical specimen as a template, the first negative mold having a hollow space substantially defined by a surface profile of the first physical specimen; producing a second physical specimen using the first negative mold; creating a second negative mold enclosing the second physical specimen therein; producing a casting piece using the second negative mold; and finishing the casting piece to produce the building component.

In one embodiment, the complimentary shapes comprise one of a linear shape, a sinusoidal wave shape, a square wave shape, a zigzag shape, and a random zigzag shape.

In one embodiment, controlling said one or more additive manufacturing apparatuses comprises, in one of said one or more additive manufacturing apparatuses, sequentially applying layers of a plastic material to construct one of the components of the first physical specimen.

In one embodiment, producing the second physical specimen comprises: pouring a hot liquid material into the hollow space of the first negative mold; and allowing the hot liquid material to cool down and solidify within the hollow space, thereby forming the second physical specimen.

In one embodiment, the hot liquid material comprises castable material (e.g., wax) and has a melting point below 100°C.

In one embodiment, producing the casting piece in the second negative mold comprises: heating the second negative mold to a temperature that liquefies the second physical specimen enclosed within the second negative mold to drain the second physical specimen out of the second negative mold, thereby forming a hollow space in the second negative mold; pouring a heated liquid material into the hollow space of the second negative mold to fill the hollow space; allowing the heated liquid material to cool down and solidify into a solid object, the solid object having substantially the same shape as defined by the digital model; and ejecting the solid object from the second negative mold to form the casting piece.

In one embodiment, pouring the heated liquid material comprises pouring a construction material having a melting point substantially greater than 100°C.

In one embodiment, the construction material comprises one of metal, glass, porcelain, and concrete.

In one embodiment, finishing the casting piece comprises polishing the casting piece in accordance with a desired finish.

In one embodiment, finishing the casting piece comprises coating the casting piece with a protection layer to increase durability.

In one embodiment, producing the first physical specimen comprises producing the first physical specimen having a 1-to-1 scale as defined in the digital model.

In one embodiment, the first physical specimen has a lateral size of at least one meter.

In accordance with another aspect, the present disclosure provides a method of creating an investment casting mold for an object. The method comprises: storing a plurality of digital subcomponent models on a non-volatile computer storage medium, each digital subcomponent model modeling a part of the object; using at least one additive manufacturing apparatuses to generate a plurality of physical subcomponents, each physical subcomponent being generated using a corresponding digital subcomponent model from among the plurality of digital subcomponent models; creating a first negative mold using the plurality of physical subcomponents as a template, the first negative mold having a hollow space substantially defined by a surface profile of the object; producing a second physical specimen using the first negative mold; and creating the investment casting mold enclosing the second physical specimen therein.

In one embodiment, the method further comprises, prior to creating the first negative mold, joining said plurality of physical subcomponents to substantially define the surface profile of the object.

In one embodiment, a boundary between two adjacent physical subcomponents among said plurality of physical subcomponents has a regular pattern shape.

In one embodiment, a boundary between two adjacent physical subcomponents among the plurality of physical subcomponents has an irregular shape.

In one embodiment, joining said plurality of physical subcomponents comprises interlocking two adjacent physical subcomponents among the plurality of physical subcomponents.

In one embodiment, creating the first negative mold comprises: creating a plurality of sub-molds, each sub-mold using a corresponding physical subcomponent as a sub-template, the corresponding physical subcomponent being from among said plurality of physical subcomponents; and joining the sub-molds to create the first negative mold.

### BRIEF DESCRIPTION OF THE DRAWINGS

FIG. 1 is a flow diagram illustrating a method of investment casting to fabricate components of an architectural building in accordance with one embodiment of the present disclosure.
FIG. 2 illustrates a process for manufacturing a cladding panel in accordance with one embodiment of the present disclosure.
FIG. 3 illustrates a process for manufacturing adaptive joints in accordance with one embodiment of the present disclosure.
FIG. 4 illustrates a process for manufacturing a complex 3D structure in free form in accordance with one embodiment of the present disclosure.
FIG. 5 illustrates exemplary boundry shapes of two neighboring parts of a digital model that defines a 3D solid object to be manufactured in accordance with embodiments of the present disclosure.

### DETAILED DESCRIPTION

The present disclosure provides a method of investment casting using additive manufacturing to produce, for example, large sized building components (e.g., having a lateral size, e.g., length or width, of at least 1 meter). With the method of the present disclosure, large sized building components become massively customizable and affordable.

Generally, mass customization is directed to the production of large amounts of customized products that eliminates the inflexibility of conventional mass production methods. A design or production process can be altered easily without incurring extra manufacturing cost, even after a production line is implemented. With the advent of new digital tools like 3D printing, complicated design and assembly (such as a car engine) with hundreds of steps and components can be reduced to only a few parts, hence simplifying and revolutionizing the design-manufacturing process.

Casting usually involves the pouring of a hot liquid material (e.g., molten metal) into a mold, which contains a hollow cavity. The hot liquid material is then allowed to cool down and solidify within the hollow cavity of the mold, thereby forming a solid object of a desired shape. The solid object is then ejected out of the mold. The shape of a mold can be defined by a disposable pattern (e.g., a wax specimen). This technique is often referred to as investment casting or lost wax. The disposable pattern can be made by hand carving a wax block or by injecting liquid wax material into a pattern die manufactured by a machining process. The pattern produced in the pattern die (which corresponds to the three-dimensional wax specimen) is then melted or burned out of the mold. Since the pattern possesses the shape of the required finished part, the casted parts carry the required shape. See, for example, U.S. Patent No. 4,844,144 issued on July 4, 1989 to Murphy et al., the entire contents of which are incorporated herein by reference.

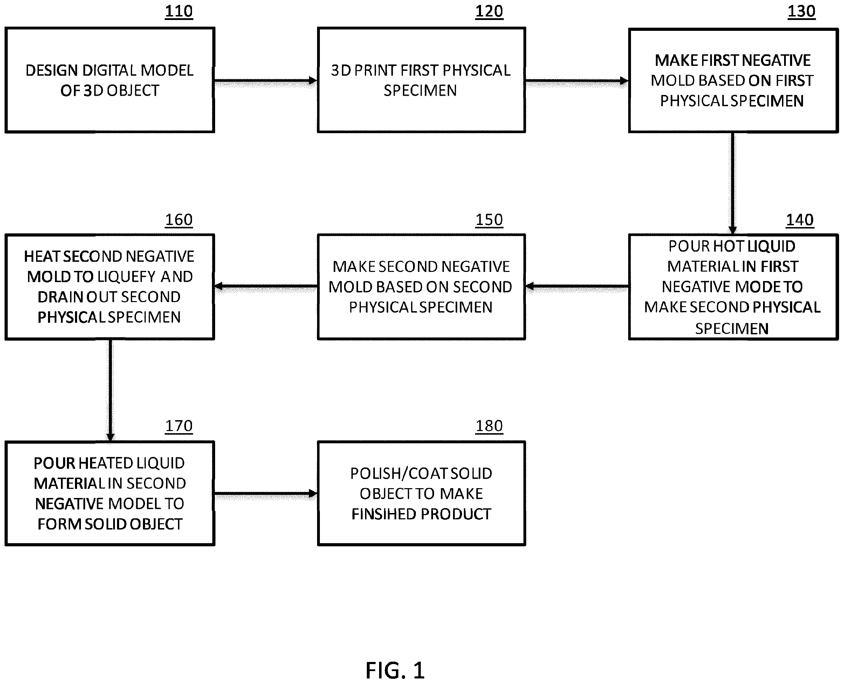

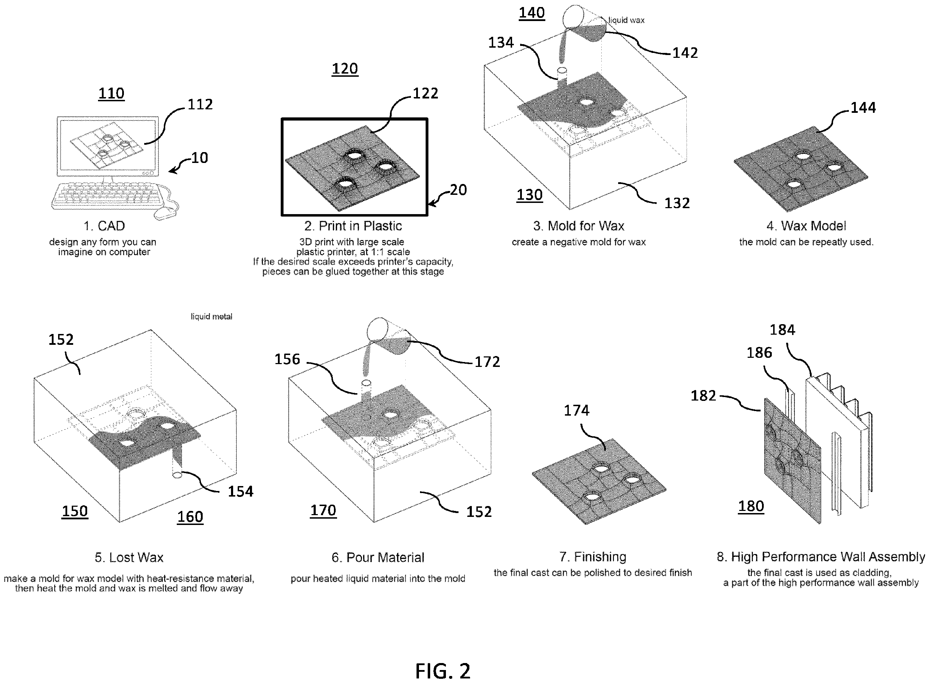

FIG. 1 is a flow diagram illustrating a method of investment casting to fabricate components of an architectural building in accordance with an embodiment of the present disclosure. FIG. 2 illustrates a process for manufacturing a cladding panel in accordance with one embodiment of the present disclosure. Hereafter, FIGs. 1 and 2 are discussed concurrently for the sake of clarity and simplicity. Referring to both FIGs. 1 and 2, in Step 110, a digital model 112 is created to define a 3D solid object to be manufactured. The digital model 112 can be created using one or more computer software packages, such as Computer Aid Design (CAD) tools, and saved in a storage device of a computer 10 as an electronic file of an appropriate format. In alternative embodiments, the digital model 112 may be created by 3D scanning a piece of art work hand crafted by an artist.

In one embodiment, the digital model 112 is designed using a cross platform method, i.e., using multiple CAD tools. Typically, an architectural building is digitally designed using a Non-Uniform Rational Basis Spline (NURBS) based, parametric software (e.g., Grasshopper that runs within Rhinoceros 3D, or CATIA of Dassault Systèmes). NURBS is a mathematical model commonly used in computer graphics for generating and representing curves and surfaces. It offers great flexibility and precision for handling both analytic and modeled shapes. In parametric software, surfaces of a 3D model can be defined using mathematical formulae and adjusted by changing parameters of the formulae.

Panelization is a process to subdivide a large complex building massing into buildable size panels (e.g., 1 meter square). However, there is no panelization feature in NURBs based software. Moreover, subdivision software, such as Maya of Autodesk, Inc. and Modo of Luxology, LLC, are not commonly used in architectural industry. Accordingly, a method to flawlessly working with subdivision geometry between parametric software (e.g., Grasshopper) and subdivision software (e.g., Modo) has been developed.

In one embodiment, different building panels are digitally created in meshes (e.g., quadrilateral or quad meshes, triangular meshes, etc.) using a subdivision or Catmull-Clark subdivision based software (e.g., Maya or Modo). Mesh is the simplest form of 3D files as it only registers the vertex locations in a three-dimensional coordinate system (e.g., Cartesian, cylindrical, or spherical). Catmull-Clark subdivision is a technique used in computer graphics to create smooth surfaces by subdivision surface modeling. The meshes are then imported into a parametric software like Rhino to rebuild. Then, the mesh vertices are registered as key parameters in the parametric software (e.g., Grasshopper). In one embodiment, each mesh remains as a mesh in the parametric software instead of being converted to mathematical formulae.

In one embodiment, movements of the vertices are controlled by the parameters (e.g., using a point attractor), thereby allowing different variations and morphing effects. That is, the digital panels in the form of meshes can morph into different shapes, and each digital panel can end up having different shapes yet sharing some similarities (i.e., mass customization). The final meshes are then re-imported into a subdivision based software (e.g., Modo) for final adjustment to turn the meshes into a smooth organic shape. The final subdivision geometry having a smooth organic shape can then be exported into a variety of mathematically well-defined format, such as, NURBS, ".OBJ," and ".STL" that can be imported directly into a 3D printing apparatus for further processing.

Referring again to FIGs. 1 and 2, in Step 120, the digital model 112 is transmitted or imported to a 3D printing apparatus 20 to produce a first physical specimen 122 having substantially the same size and shape as defined by the digital model 112 (i.e., a 1-to-1 scale). The 3D printing apparatus 20 is programmed to produce the first physical specimen 112 by successively depositing layers of a 3D printable material based on the digital model 112. In one embodiment, the 3D printable material of the first physical specimen 122 comprises a hard plastic material. It is appreciated that, depending on the 3D printing technologies used, the first physical specimen 122 may comprise polylactic acid (PLA) or acrylonitrile butadiene styrene (ABS) for FDM printers, or resin for SLA printers.

In certain embodiments, the 3D object as defined by the digital model 112 may be too large in size to 3D print with an available 3D printing apparatus 20. Accordingly, it is impossible to 3D print the first physical specimen 122 in a single batch. As such, digital model 112 may be divided into multiple parts that can each be 3D printed using 3D printing apparatus 20. These parts may be produced as components of first physical specimen 122 using single 3D printing apparatus 20. For example, the components may be 3D printed sequentially by 3D printing apparatus 20, concurrently using multiple 3D printing apparatuses, or in any other suitable way. The 3D printed components can then be combined to form the complete first physical specimen 122. Depending on the material used to produce the first physical specimen 122, components of the first physical specimen 122 can be combined by any appropriate method, such as, pressing, mechanical fastening, adhesive bonding, welding, thermal fusion, and the like.

To produce the components of the first physical specimen 122 separately, the digital model 112 may be divided into multiple parts using a software package executed, for example, on the computer 10, each part corresponding to a component of the first physical specimen 122. Each part of the digital model 112 can be generated from the original digital model 122 and transmitted or imported to one or more 3D printing apparatuses to produce a respective component of the first physical specimen 122.

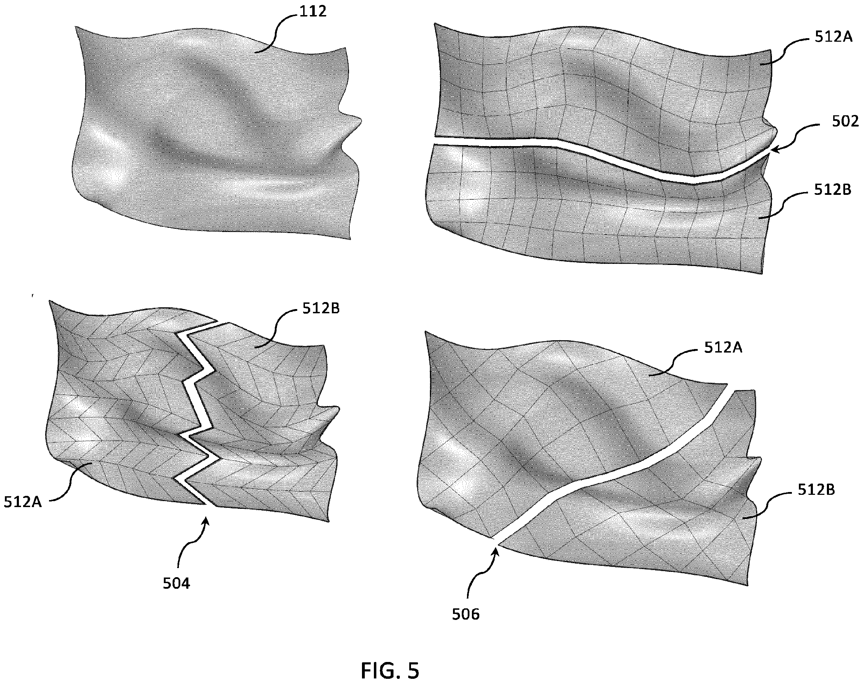

In some embodiments, the multiple parts of the digital model 112 are generated by using the software package executed on the computer 10 to apply a predetermined boundary rule to the digital model 112, such that neighboring parts of the digital model 112 can form a boundary of complimentary shapes. FIG. 5 illustrates exemplary boundry shapes of two neighboring parts 512A and 512B of the digital model 112 in accordance with embodiments of the present disclosure. The boundary of two neighboring parts 512A and 512B of the digital model 112 may be determined in any suitable way. In some embodiments, the boundary is specially shaped as a regular pattern 502, 504 (such as, a linear shape, a sinusoidal wave shape, a square wave shape, etc.) or an irregular shape 506 (such as, a random zigzag shape). In some embodiments, the boundaries are to produce interlocking parts. As a result, each component of the first physical specimen 122 can be made in accordance with a respective part of the digital model 112 including specially shaped boundaries, if desired. The specially shaped boundaries can increase the bonding area of two neighboring components of the first physical specimen 122 and thus enhance the structural strength of the combination. In alternative embodiments, when generating parts of the digital model 112, the boundary rule may define the sides of two neighboring parts of the digital model 112 in accordance with a predetermined joinery style, such as, a splice joint.

In certain embodiments, the 3D printing apparatus 20 may receive the digital model 112 in its entirety as originally designed in computer 10. Before 3D printing the first physical specimen 122, the 3D printing apparatus 20 may convert the digital model 112 into multiple parts by applying a boundary rule to the received digital model 112, as described above, using a software package executed on the 3D printing apparatus 20.

In Step 130, a first negative mold 132 is produced using the first physical specimen 122 as a template, such that a hollow space is formed in the first negative mold 132. The hollow space of the first negative mold 132 has a shape substantially identical to the surface profile of the first physical specimen 122. In the case where multiple components of the first physical specimen 122 are 3D printed separately, multiple first negative molds 132 can be made, each corresponding to a respective one of the multiple components of the first physical specimen 122. In such a case, the multiple first negative molds 132 can be combined to form a large-scaled negative mold having a hollow space substantially as defined by the digital model 112. The multiple first negative molds 132 can be polished and refined at the boundary areas to reduce granularity.

One or more input channels 134 may be introduced to first negative mold 132 such that the hollow space may be accessed. Input channel 134 may be formed by drilling first negative mold 132, or in any other suitable way. First negative mold 132 may be made of silicone which is a commonly used mold material for casting wax, or rubber which is a cheaper alternative, or any other suitable material. In some embodiments, the material of first negative mold 132 has a melting point greater than a hot liquid material 142 (introduced in Step 140).

In Step 140, a hot liquid material 142 is poured into the hollow space of the first negative mold 132 through an input channel 134 of the first negative mold 132, thereby filling the entire hollow space. In one embodiment, the liquid material 142 comprises an organic material (e.g., wax) that forms a hydrophobic and malleable solid at room temperature. In one embodiment, the organic material has a melting point in the range of about 40°C to 80°C, or substantially less than 100°C. The hot liquid material 142 is allowed to cool down and solidify within the hollow space of the first negative mold 132, thereby forming a second physical specimen 144 (or wax replicate). Second physical specimen 144 is then removed from first negative mold 132.

In Step 150, a second negative mold 152 is produced with the second physical specimen 144 enclosed therein. In one embodiment, the second negative mold 152 is made of a heat-resistant material (e.g., ceramic, plaster, sand, etc.) and includes an output channel 154 and an input channel 156. In certain embodiments, input channel 156 and output channel 154 may be identical. In one embodiment, the heat-resistant material may remain in a solid form even when heated to a temperature of greater than 1000°C. Selection of the heat-resistant material for the second negative mold 152 depends on the material to be casted. The melting point of the heat-resistant material of the second negative mold 152 must be substantially greater than that of the material to be casted. For example, aluminum has a low melting point of about 660°C, and thus can be casted using molds of most materials. However, stainless steel has a melting point of about 1300°C, which is greater than the melting point of plaster (having a workable temperature of about 1200°C). Therefore, stainless steel cannot be casted in a paster mold and thus must be casted in a mold having a much higher melting point, such as a sand mold.

It is appreciated that, in certain embodiments, the second negative mold 152 can be made directly from the first physical specimen 122, without performing Steps 130 and 140. That is, depending on the 3D printable materials (e.g., plastic or wax), first physical specimen 122 may be 3D printed to a large enough size to make the second negative mold 152 directly, such that Steps 130 and 140 can be avoided. It is also appreciated that, in certain other embodiments, one or more iterations of Steps 130 and 140 may be required.

In Step 160, the second negative mold 152 is heated to a temperature that liquefies the second physical specimen 144 in the second negative mold 152. As a result, the liquefied second physical specimen 144 can flow and drain out of the second negative mold 152 through the output channel 154, thereby forming a hollow space in the second negative mold 152. The hollow space has a shape that is substantially identical to a surface profile of the second physical specimen 144.

In Step 170, a heated liquid material 172 is poured into the hollow space of the second negative mold 152 through the input channel 156, thereby filling the entire hollow space. The heated liquid material 172 is then allowed to cool down and solidify into a solid object 174 having substantially the same shape as defined by the digital model 112. The solid object 174 is then ejected out of the second negative mold 152 for further processing. In various embodiments, the heated liquid material 172 may be a construction material having a high melting point, such as, metal (e.g., silver, gold, brass, bronze, tin, aluminum, etc.), glass, porcelain, concrete, and the like. In one embodiment, the construction material has a melting point in the range of about 200°C to 2000°C, or substantially greater than 100°C. It is appreciated that the melting point of the heated liquid material 172 must be substantially lower than that of the heat-resistant material of the second negative mold 152.

In Step 180, the solid object 174 is polished in accordance with a desired finish or coated with a protection layer (e.g., one or more layers of anti-corrosion paint) to increase durability, thereby forming a finished product 182. In one embodiment, the finished product 182 can be a cladding to be attached to a wall assembly 184 through a wall tie 186 and installed to an architectural construction. With the technology of the present disclosure, claddings can be made into complex 3D form and pattern, while still serving its protective function for the building.

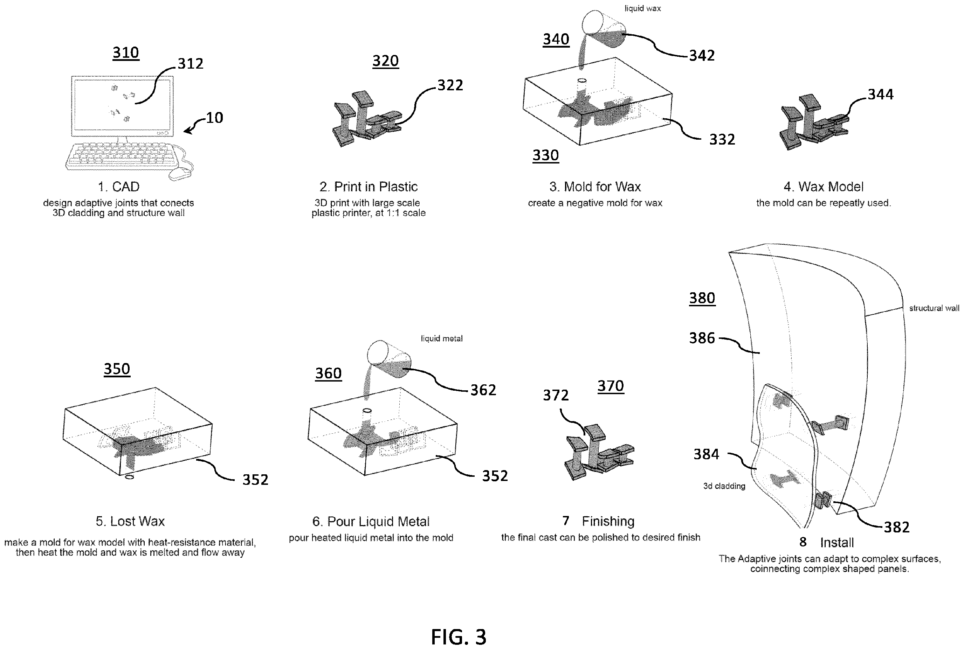

FIG. 3 illustrates a process for manufacturing adaptive joints in accordance with one embodiment of the present disclosure. The process shown in FIG. 3 is similar to that shown in FIG. 2, except that adaptive joints are manufactured instead of panels. An adaptive joint is a structural detail that attaches the cladding panel to the structural wall. Using the method of the present disclosure, highly complicated adaptive joints can be created for different scenarios that adapts to different situations of a complex building surface.

Referring to FIG. 3, in Step 310, one or more adaptive joints for an architectural building are digitally designed using one or more CAD tools as digital models 320. In Step 320, the digital models 312 are imported into a large-scale 3D printer to manufacture, layer-by-layer, first physical specimens 322 in actual size as designed (i.e., 1-to-1 scale). In one embodiment, first physical specimens 322 comprise a hard plastic material. In Step 330, a first negative mold 332 is created to have a hollow cavity as defined by the first physical specimens 322. In Step 340, a liquid material 342 (e.g., liquid wax) is poured into the hollow cavity to make second physical specimens 344. In one embodiment, the second physical specimens 344 comprise castable material (eg. wax or castable plastic) replicates of the first physical specimen 322.

Referring again to FIG. 3, in Step 350, a second negative mold 352 is made using a heat-resistant material enclosing one or more of the second physical specimens 344, and heated to drain away the castable material (e.g., wax) replicates, leaving a hollow cavity therein. In Step 360, a heated liquid material (e.g., metal) 362 is poured into the hollow cavity of the second negative mold 352, and allowed to cool down and solidify therein. In Step 370, the solidified cast pieces 372 are ejected from the second negative mold 352, and polished or coated to make the designed adaptive joints 382 with a desired finish or durability. In Step 380, the adaptive joints 382 are used to connect a 3D cladding 384 and a structural wall 386, both being complex shaped building components. In one embodiment, the adaptive joints 382 can have a dimension (e.g., length or width) of less than one meter.

With the adaptive joints so manufactured, a structural detail where claddings are attached to the building wall can be attached at any degree of corresponding angle to gravitational and/or lateral forces. As such, claddings can be extended into roof and overhead ceiling categories. It is appreciated that the same method can be applied to make other building components, such as, building structures and building interiors.

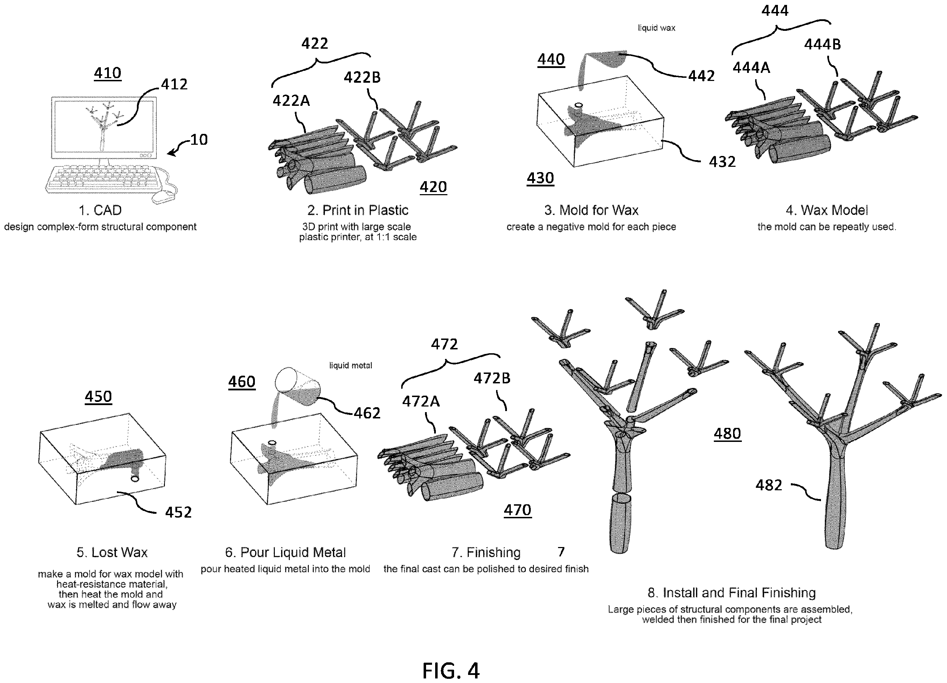

FIG. 4 illustrates a process for manufacturing a complex 3D structure in free form based on the method of the present disclosure as shown in FIG. 1. The process shown in FIG. 4 is similar to that shown in FIGs. 2 and 3, except that components of the complex 3D structure are manufactured instead of panels and adaptive joints.

Referring to FIG. 4, in Step 410, a complex 3D structure and components thereof are digitally designed using one or more CAD tools as digital models 412. Due to the horizontality nature of the complex 3D structure (e.g., columns), design can be divided into different parts with the longest dimension not exceeding four meters. In Step 420, the digital models 412 are imported into one or more 3D printers to manufacture, layer-by-layer, first physical specimens 422 in actual size as designed (i.e., 1-to-1 scale). In one embodiment, first physical specimens 422 include first structural trunk specimens 422A and first structural branch specimens 422B, each comprising a hard plastic material. In Step 430, one or more first negative molds 432 are created each having a hollow cavity as defined by a respective one of the first structural trunk specimens 422A and the first structural branch specimens 422B. In Step 440, a liquid material 442 (e.g., liquid wax) is poured into the hollow cavity of the first negative molds 432 to make second physical specimens 444, including second structural trunk specimens 444A and second structural branch specimens 444B. In one embodiment, the second structural trunk specimens 444A and the second structural branch specimens 444B comprise castable material (eg. wax) replicates of the first structural trunk specimens 422A and the first structural branch specimens 422B.

Referring again to FIG. 4, in Step 450, one or more second negative molds 452 are made using a heat-resistant material each enclosing one or more of the second physical specimens 444, and heated to drain away the castable material (e.g., wax) replicates, leaving a hollow cavity therein. In Step 460, a heated liquid material (e.g., metal) 462 is poured into the hollow cavity of the second negative molds 452, and allowed to cool down and solidify therein. In Step 470, the solidified cast pieces 472 are ejected from the second negative molds 452, and polished or coated to make the designed structural components (e.g., structural trunks 472A and structural branches 472B) with a desired finish or durability. In Step 480, the structural trunks 472A and the structural branches 472B are assembled together (e.g., by welding), so as to form a finished product for the desired complex 3D structure 482. In one embodiment, the complex 3D structure 482 can have a dimension (e.g., height) of greater than one meter.

In view of the above, one of ordinary skill in the art would find the method of the present disclosure advantageous in that building components can be "3D printed" utilizing a free form and highly customizable three dimensional shapes, with choices of material and adaptive structural integrity. Buildings no longer need to be designed and built in a rectangular and/or stack box fashion. The fabrication constraints of architectural elements, such as façade, structure, and interior space, are reduced allowing for greater creativity and diversity. Panels no longer have to be rectangular planes-they can be three-dimensional with complex detailing. Structural columns no longer need to be in a simple cylinder shape. With the method of the present disclosure, building components having a size of about 4 m x 3 m x 3 m, more or less, can be manufactured with complex forms and shapes. Therefore, new norm in the architectural industry can be created. Space frame, for example, can be designed with complex details and ornaments with same or similar efficiency and similar cost as compared with the prior art.

In addition, the method of the present disclosure is advantageous in that 3D printed panels (in plastic or other material) can be welded or otherwise combined together to produce a large-scale mold, thereby creating the negative mold for the final cast. This eliminates the size limitation of existing 3D printers. Refinement of the combination boundaries can be done either to the negative molds or to the casted panels for perfection.

Materialwise, cast metal, glass, or stone façades are already a common practice for buildings with a character. Once a mold and/or a plastic specimen is made, it can be used over and over again. With the method of the present disclosure, a better building can be designed and built potentially at a lower cost. Using metal as an example, it will not be limited to façade or interior walls, but also applicable to other structures, such as railings and other architectural components. The size of current 3D-printed metal in architecture industry is less than 0.1 cubic meters, and only used for small objects, such as, door handles.

Moreover, it is very expensive to manufacture using conventional 3D printing technology. For example, it takes up to 24 hours to print a piece using DMLS technology, and it cannot be replicated easily. With the method of the present disclosure, 3D printing is no longer limited to scale, and can achieve greater economy.

For the purposes of describing and defining the present disclosure, it is noted that terms of degree (e.g., "substantially," "slightly," "about," "comparable," etc.) may be utilized herein to represent the inherent degree of uncertainty that may be attributed to any quantitative comparison, value, measurement, or other representation. Such terms of degree may also be utilized herein to represent the degree by which a quantitative representation may vary from a stated reference (e.g., about 10% or less) without resulting in a change in the basic function of the subject matter at issue. Unless otherwise stated herein, any numerical values appeared in this specification are deemed modified by a term of degree thereby reflecting their intrinsic uncertainty.

Although various embodiments of the present disclosure have been described in detail herein, one of ordinary skill in the art would readily appreciate modifications and other embodiments without departing from the spirit and scope of the present disclosure as stated in the appended claims.

In general, in at least one embodiment, the methods and/or the apparatus according to the present invention be provided according to at least one of the following aspect:
1. A method of investment casting using additive manufacturing, the method comprising:
   creating a digital model of a building component using one or more software tools executed on a computer device and importing the digital model in an additive manufacturing apparatus;
   producing a first physical specimen by controlling the additive manufacturing apparatus in accordance with the digital model;
   creating a first negative mold using the first physical specimen as a template, the first negative mold having a hollow space substantially defined by a surface profile of the first physical specimen;
   producing a second physical specimen using the first negative mold;
   creating a second negative mold enclosing the second physical specimen therein;
   producing a casting piece using the second negative mold; and
   finishing the casting piece to produce the building component.
2. The method of aspect 1, wherein creating the digital model comprises dividing the digital model into a plurality of digital model parts by applying a predetermined boundary rule to the digital model such that boundaries of neighboring digital model parts have complimentary shapes.
3. The method of aspect 2, wherein the complimentary shapes comprise at least one of a linear shape, a sinusoidal wave shape, a square wave shape, a zigzag shape, and a random zigzag shape.
4. The method of aspect 2, wherein producing the first physical specimen comprises:
   producing components of the first physical specimen by controlling one or more additive manufacturing apparatuses in accordance with the digital model parts, each of the digital model parts defining a respective one of the components of the first physical specimen; and
   combining the components to form the first physical specimen.
5. The method of aspect 1, wherein controlling the additive manufacturing apparatus comprises sequentially applying layers of a plastic material to construct the first physical specimen.
6. The method of aspect 1, wherein producing the second physical specimen comprises:
   pouring a hot liquid material into the hollow space of the first negative mold; and
   allowing the hot liquid material to cool down and solidify within the hollow space, thereby forming the second physical specimen.
7. The method of aspect 6, wherein the hot liquid material comprises castable material and has a melting point below 100°C.
8. The method of aspect 7, wherein the castable material comprises wax.
9. The method of aspect 1, wherein producing the casting piece in the second negative mold comprises:
   heating the second negative mold to a temperature that liquefies the second physical specimen enclosed within the second negative mold to drain the second physical specimen out of the second negative mold, thereby forming a hollow space in the second negative mold;
   pouring a heated liquid material into the hollow space of the second negative mold to fill the hollow space;
   allowing the heated liquid material to cool down and solidify into a solid object, the solid object having substantially the same shape as defined by the digital model; and
   ejecting the solid object from the second negative mold to form the casting piece.
10. The method of aspect 9, wherein pouring the heated liquid material comprises pouring a construction material having a melting point substantially greater than 100°C.
11. The method of aspect 10, wherein the construction material comprises at least one of metal, glass, porcelain, and concrete.
12. The method of aspect 1, wherein finishing the casting piece comprises polishing the casting piece in accordance with a desired finish.
13. The method of aspect 1, wherein finishing the casting piece comprises coating the casting piece with a protection layer to increase durability.
14. The method of aspect 1, wherein producing the first physical specimen comprises producing the first physical specimen having a 1-to-1 scale as defined by the digital model.
15. The method of aspect 14, wherein the first physical specimen has a lateral size of at least one meter.
16. A method of investment casting using additive manufacturing, the method comprising:
   creating a digital model of a building component using one or more software tools executed on a computer device and importing the digital model in an additive manufacturing apparatus, the digital model comprises a plurality of digital model parts with boundaries of neighboring digital model parts having complimentary shapes;
   producing components of a first physical specimen by controlling one or more additive manufacturing apparatuses in accordance with the digital model parts, each of the digital model parts defining a respective one of the components of the first physical specimen, and combining the components to form the first physical specimen;
   creating a first negative mold using the first physical specimen as a template, the first negative mold having a hollow space substantially defined by a surface profile of the first physical specimen;
   producing a second physical specimen using the first negative mold;
   creating a second negative mold enclosing the second physical specimen therein;
   producing a casting piece using the second negative mold; and
   finishing the casting piece to produce the building component.
17. The method of aspect 16, wherein the complimentary shapes comprise one of a linear shape, a sinusoidal wave shape, a square wave shape, a zigzag shape, and a random zigzag shape.
18. The method of aspect 16, wherein controlling said one or more additive manufacturing apparatuses comprises, in one of said one or more additive manufacturing apparatuses, sequentially applying layers of a plastic material to construct one of the components of the first physical specimen.
19. The method of aspect 16, wherein producing the second physical specimen comprises:
   pouring a hot liquid material into the hollow space of the first negative mold; and
   allowing the hot liquid material to cool down and solidify within the hollow space, thereby forming the second physical specimen.
20. The method of aspect 19, wherein the hot liquid material comprises castable material and has a melting point below 100°C.
21. The method of aspect 20, wheein the castable material comprises wax.
22. The method of aspect 16, wherein producing the casting piece in the second negative mold comprises:
   heating the second negative mold to a temperature that liquefies the second physical specimen enclosed within the second negative mold to drain the second physical specimen out of the second negative mold, thereby forming a hollow space in the second negative mold;
   pouring a heated liquid material into the hollow space of the second negative mold to fill the hollow space;
   allowing the heated liquid material to cool down and solidify into a solid object, the solid object having substantially the same shape as defined by the digital model; and
   ejecting the solid object from the second negative mold to form the casting piece.
23. The method of aspect 22, wherein pouring a heated liquid material comprises pouring a construction material having a melting point substantially greater than 100°C.
24. The method of aspect 23, wherein the construction material comprises at least one of metal, glass, porcelain, and concrete.
25. The method of aspect 16, wherein finishing the casting piece comprises polishing the casting piece in accordance with a desired finish.
26. The method of aspect 16, wherein finishing the casting piece comprises coating the casting piece with a protection layer to increase durability.
27. The method of aspect 16, wherein producing the first physical specimen comprises producing the first physical specimen having a 1-to-1 scale as defined by the digital model.
28. The method of aspect 27, wherein the first physical specimen has a lateral size of at least one meter.
29. A method of creating an investment casting mold for an object, the method comprising:
   storing a plurality of digital subcomponent models on a non-volatile computer storage medium, each digital subcomponent model modeling a part of the object;
   using at least one additive manufacturing apparatus to generate a plurality of physical subcomponents, each physical subcomponent being generated using a corresponding digital subcomponent model from among the plurality of digital subcomponent models;
   creating a first negative mold using the plurality of physical subcomponents as a template, the first negative mold having a hollow space substantially defined by a surface profile of the object;
   producing a second physical specimen using the first negative mold; and
   creating the investment casting mold enclosing the second physical specimen therein.
30. The method of aspect 29, further comprising, prior to creating the first negative mold, joining said plurality of physical subcomponents to substantially define the surface profile of the object.
31. The method of aspect 30, wherein a boundary between two adjacent physical subcomponents among said plurality of physical subcomponents has a regular pattern shape.
32. The method of aspect 30, wherein a boundary between two adjacent physical subcomponents among the plurality of physical subcomponents has an irregular shape.
33. The method of aspect 30, wherein joining said plurality of physical subcomponents comprises interlocking two adjacent physical subcomponents among the plurality of physical subcomponents.
34. The method of aspect 29, wherein creating the first negative mold comprises:
   creating a plurality of sub-molds, each sub-mold using a corresponding physical subcomponent as a sub-template, the corresponding physical subcomponent being from among said plurality of physical subcomponents; and
   joining the sub-molds to create the first negative mold.
35. An additive manufacturing apparatus having executed thereon a computer softare package, the additive manufacturing apparatus being configured to receive a digital model associated with a three-dimensional solid object to be manufactured and convert the digital model into multiple digital model parts by applying a predetermined boundary rule to the digital model using the computer softare package, each digital model part corresponding to a respective one of component parts of the three-dimensional solid object, the additive manufacturing apparatus being further configured to manufacture, layer by layer, at least one of the component parts of the three-dimensional solid in accordance with instructions defined in a corresponding one of the digital model parts.

## Claims

1. A method of investment casting using additive manufacturing, the method comprising:
creating a digital model of a building component using one or more software tools executed on a computer device and importing the digital model in an additive manufacturing apparatus;
producing a first physical specimen by controlling the additive manufacturing apparatus in accordance with the digital model;
creating a first negative mold using the first physical specimen as a template, the first negative mold having a hollow space substantially defined by a surface profile of the first physical specimen;
producing a second physical specimen using the first negative mold;
creating a second negative mold enclosing the second physical specimen therein;
producing a casting piece using the second negative mold; and
finishing the casting piece to produce the building component.

2. The method of claim 1, wherein creating the digital model comprises dividing the digital model into a plurality of digital model parts by applying a predetermined boundary rule to the digital model such that boundaries of neighboring digital model parts have complimentary shapes.

3. The method of claim 2, wherein the complimentary shapes comprise at least one of a linear shape, a sinusoidal wave shape, a square wave shape, a zigzag shape, and a random zigzag shape.

4. The method of claim 2, wherein producing the first physical specimen comprises:
producing components of the first physical specimen by controlling one or more additive manufacturing apparatuses in accordance with the digital model parts, each of the digital model parts defining a respective one of the components of the first physical specimen; and
combining the components to form the first physical specimen.

5. The method of claim 1, wherein controlling the additive manufacturing apparatus comprises sequentially applying layers of a plastic material to construct the first physical specimen.

6. The method of claim 1, wherein producing the second physical specimen comprises:
pouring a hot liquid material into the hollow space of the first negative mold; and
allowing the hot liquid material to cool down and solidify within the hollow space, thereby forming the second physical specimen.

7. The method of claim 6, wherein the hot liquid material comprises castable material and has a melting point below 100°C.

8. The method of claim 7, wherein the castable material comprises wax.

9. The method of claim 1, wherein producing the casting piece in the second negative mold comprises:
heating the second negative mold to a temperature that liquefies the second physical specimen enclosed within the second negative mold to drain the second physical specimen out of the second negative mold, thereby forming a hollow space in the second negative mold;
pouring a heated liquid material into the hollow space of the second negative mold to fill the hollow space;
allowing the heated liquid material to cool down and solidify into a solid object, the solid object having substantially the same shape as defined by the digital model; and
ejecting the solid object from the second negative mold to form the casting piece.

10. The method of claim 9, wherein pouring the heated liquid material comprises pouring a construction material having a melting point substantially greater than 100°C.

11. The method of claim 10, wherein the construction material comprises at least one of metal, glass, porcelain, and concrete.

12. The method of claim 1, wherein finishing the casting piece comprises polishing the casting piece in accordance with a desired finish.

13. The method of claim 1, wherein finishing the casting piece comprises coating the casting piece with a protection layer to increase durability.

14. The method of claim 1, wherein producing the first physical specimen comprises producing the first physical specimen having a 1-to-1 scale as defined by the digital model.

15. The method of claim 14, wherein the first physical specimen has a lateral size of at least one meter.
